# EUROPEAN PATENT APPLICATION

(11) **EP 1 089 212 A2**
(43) Date of publication of application: **04.04.2001**
(21) Application number: 00118128.8
(22) Date of filing: 28.08.2000
(51) Int. Cl.: G06K 7/00

(54) **A plug-in card for electronic devices**

(30) Priority: 01.10.1999 DE 19947162
(71) Applicant: ITT MANUFACTURING ENTERPRISES, INC., Wilmington, Delaware 19801 (US)
(72) Inventor: Schremmer, Andreas, 73614 Schorndorf (DE)
(74) Representative: Dreiss, Fuhlendorf, Steimle & Becker, Patentanwälte

(57) **Abstract**

The invention relates to a plug-in card (10) for electronic devices of approximately oblong, flat formation, with a housing comprising an upper and a lower, substantially half-shell-shaped housing part (13), a circuit board (16) accommodated in the housing, a contacting device (23) for a chip card (20) such as for example a SIM-, CCM- or the like card, and an accommodating means (21) for the chip card (20). It is provided that the chip card accommodating means (21) comprises a frame-like element (22, 122, 222) which is mounted on the laminar side of one of the housing parts (13, 113, 213) and is at least partially connected to an opening (24) in the laminar side of the relevant housing part (13) and in which the inserted chip card (20) can be accommodated, guided to the contacting device (23), and that the contacting device (23) is accommodated at one end of the frame-like element (22).

## Description

The present invention relates to a plug-in card for electronic devices according to the preamble of Claim 1.

Such plug-in cards are used for example as PC-cards according to the standards of the "Personal Computer Memory Card Industry Association" (PCMCIA) in portable computers (for example laptops, notebooks) in which the identification of the user for the use of, or access to, a service is required by means of a chip card, such as for example a SIM- or CCM-card. Such services can relate for example to credit cards, on-line services or the mobile telephone network.

In the case of such plug-in cards, which are provided with an accommodating means for a chip card, the required small structural height of the for example PC card of approximately 5 mm must be taken into account; moreover the PC-card is to remain closed for the exchange of the chip card (SIM-, CCM-card). Additionally the stability of the PC-card should not be impaired so that the chip card can be inserted and removed as easily as possible.

A plug-in card is known for example, wherein the chip card accommodating means is a separate component which can be inserted into the plug-in card and into the pivoted cover of which the chip card is plugged in (ITT Cannon Brochure "CCM-Plug Connector for Chip Cards 12/95"). In the case of this known accommodating means on the one hand the structural height is problematic and on the other hand shielding problems arise in respect of the synthetic resin cover.

In the case of another plug-in card known from WO 97/39418, the accommodating means is designed such that the chip card is inserted from the narrow side of the plug-in card. This type of chip card accommodating means on the narrow side of the plug-in card affects the stability of the plug-in card as an opening must be provided on the narrow side, which is substantially responsible for the rigidity. Therefore in most cases such an accommodating means requires a frameless plug-in card as otherwise the supporting frame must be interrupted.

Therefore the object of the present invention is to provide a plug-in card for electronic devices of the type referred to in the introduction, the chip card accommodating means of which does not impair or negatively influence the structural height and stability of the plug-in card.

This object is achieved in that the features described in Claim 1 are provided in a plug-in card for electronic devices of the type referred to in the introduction.

The measures according to the invention provide that the chip card accommodating means can be used not only for frameless plug-in cards but also for those with a bracing frame without impairing the stability of the plug-in card. Due to the direct arrangement of the frame-like element on one of the housing parts, the required small structural height of the plug-in card is retained. As the frame is pre-mounted on the one housing part, a simplified assembly of the plug-in card is achieved.

In accordance with a preferred embodiment according to the features of Claim 2 the frame-like element is secured on the underneath of the relevant housing part.

Preferably, the corresponding feature of Claim 3 is for example adhesively attached via a double-sided adhesive strip.

In accordance with another development according to the features of Claim 4, the frame-like element can also be inserted into the opening in the relevant housing part and its edge portion can rest on the upper side of the housing part. Here the upper side of the relevant housing part can be provided with a small depression around the opening.

The features according to Claim 5 and/or Claim 6 result in a simple insertion and removal of the chip card into/from the plug-in card in terms of handling technology.

In a development, the features according to Claim 7 are provided which facilitate a simple production of frame-like element and contacting device. Expediently, the features according to Claim 8 are provided here. In this case it is expedient for the contact arms of the contacting device, which contact the relevant conductor paths of the circuit board, to be of sprung construction.

In another development according to the features of Claim 9, the frame-like element and the contacting device are formed as separate components, such that the contacting device is attached to the circuit board and following the assembly of the plug-in card is accommodated in the recess of the frame-like component mounted on the housing part. Here it is expedient to provide the features of Claim 10, i.e. to attach the contacting device to the circuit board by a soldering connection.

The features according to Claim 11 provide that the chip card can be readily removed from its use state, in which it is inserted in the plug-in card, by a finger-tip and thus by frictional engagement.

Further details of the invention may be gathered from the following description in which the invention is described and explained in detail in the form of the exemplary embodiments illustrated in the drawing in which:
- Figure 1: is an exploded, perspective view of a part of a plug-in card for electronic devices according to a first exemplary embodiment of the present invention,
- Figure 2: is a perspective view of the part of the plug-in card assembled from the components shown in Figure 1,
- Figure 3: is a diagram corresponding to Figure 1 but according to another exemplary embodiment of the present invention and
- Figure 4: is a diagram corresponding to Figure 1 but according to a variant of Figure 3.

As can be seen from the drawing, the plug-in card 10, 110, 210 according to the illustrated exemplary embodiments of the present invention, which is suitable for use in electronic devices, comprises an oblong and very flat frameless housing which is composed of a lower metallic housing part (not shown) and an upper metallic housing part 13, 113, 213 which is connectible or connected to said lower part by locking engagement at its longitudinal edge. A unit 14 is arranged and fixed between the lower housing part (not shown) and the upper housing part 13, 113, 213, which unit 14 comprises a circuit board 16 equipped with electronic components in a manner which has not been illustrated and, arranged at at least one transverse end of the circuit board 16, a plug-in connector (likewise not shown) connected thereto. The plug-in card 10, 110, 210 further comprises a device 21, 121, 221 for accommodating and holding a chip card 20, for example in the form of a SIM-, CCM- or the like card, as is used for plug-in cards, designed as PC cards according to the standards of the "Personal Computer Memory Card Industry Association (PCMCIA)", in portable computers, such as lap-tops, notebooks and the like.

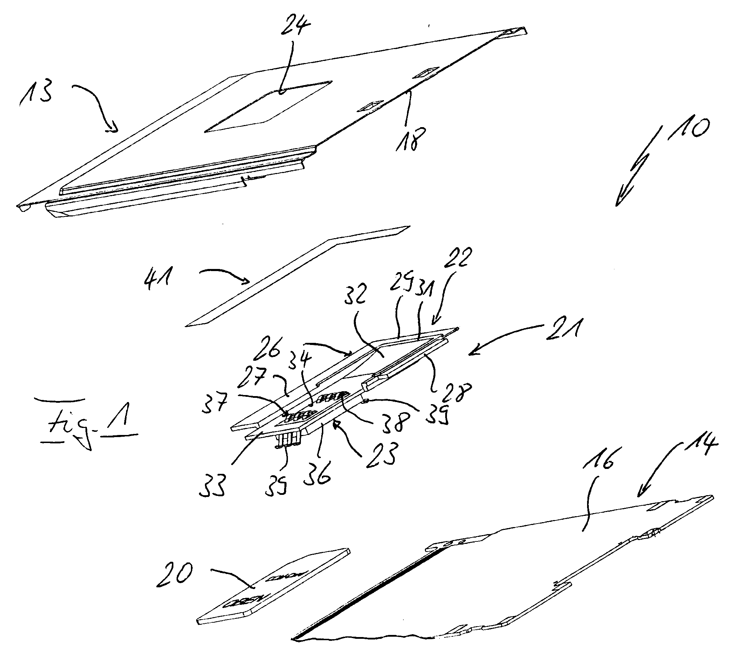

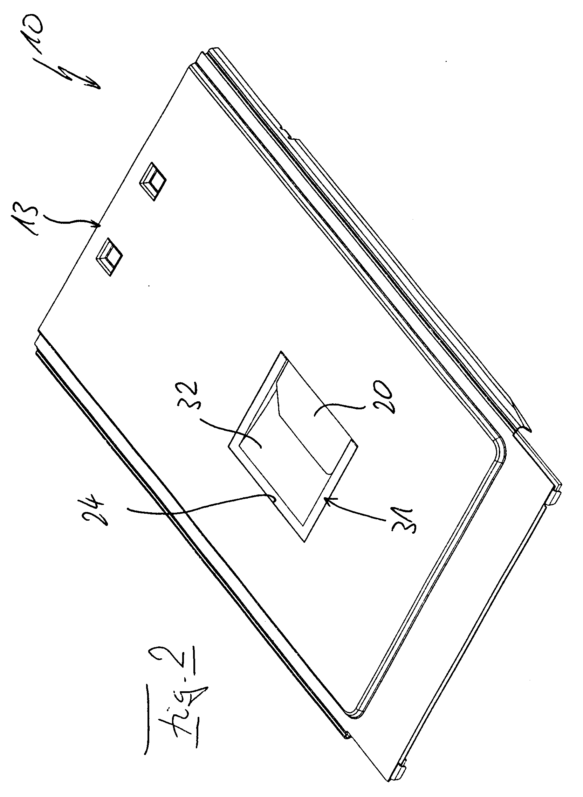

The device 21 according to the first exemplary embodiment of Figures 1 and 2 comprises a frame-like element 22 made of synthetic resin and a contact block or contacting device 23 which is electrically connectible to the circuit board 16. For the device 21, whose frame-like element 22 is provided and designed to accommodate the chip card 20 in guiding manner, in the upper housing part 13 a rectangular opening 24 is provided through which the chip card 20 can be brought to the contacting device 23 via the frame-like element 22.

The frame-like element 22 has a substantially approximately U-shaped frame 26 with legs of different length, of which the long leg 27 is wider than the parallel short leg 28. The two longitudinal legs 27 and 28 are connected by a transverse leg 29, the width of which corresponds approximately to that of the short longitudinal leg 28. The frame legs 27, 28 and 29 have a U-shaped, flange-like elevation 31, a ramp 32 extending in sloping fashion from the upper side of the transverse part of said elevation to the lower side thereof and continuing into a lower guide plate 33, the plane of which extends in parallel to the plane of the frame legs 27 to 29 and which projects beyond the long longitudinal leg 27. A mounting plate 36 of the contacting device 23 is arranged inside the guide plate 33. Contacts 37 of the contacting device 23 are inserted, and held stationery, in the mounting plate 36. The contacts 37 comprise first upper sprung ends 38, which project beyond the mounting plate 36 and which contact the chip card 20, and second, lower sprung ends 39 which in the assembled state contact the relevant conductor paths of the circuit board 16. The mounting plate 36 is thicker than the guide plate, their upper sides being aligned flush with one another.

In Figure 1 the connection between the mounting plate 36 and the guide plate 33 is illustrated such that the mounting plate 36 is firmly inserted in a recess 34 of the guide plate 33 either by force-locking engagement or by an adhesive connection. In accordance with a variant, the frame-like element 22 and the contacting device 23 form an integral component such that guide plate 33 and mounting plate 36 form one piece, the contacts 37 being injection-moulded into this one-piece plate 33, 36.

The consequently integral component comprising frame-like element 22 and contacting device 23 is attached to the underneath 18 of the upper housing part 13 in such manner that the U-shaped elevation 31 of the frame 26 is arranged inside the opening 24 and bears against the inner edges thereof. In the illustrated exemplary embodiment an attachment in the form of an adhesion of housing part 13 and frame-like element 22 is employed. For this purpose a L-shaped, double-sided adhesive strip 41 is used which, adjacent to the U-shaped elevation 31, is adhesively attached on the one hand to the long longitudinal leg 27 and the transverse leg 29, and on the other hand to the underneath 18 of the housing part 13 surrounding the opening 24 in parts. In this way, prior to the full assembly of the plug-in card 10, the device 21 is pre-mounted on the upper housing part 13, and specifically in such a way that upon the full assembly of the plug-in card 10 a corresponding contacting is readily achieved between the second sprung ends 39 of the contacts 37 and the relevant conductor paths of the circuit board 16.

In accordance with Figure 2, in the described pre-mounted state the U-shaped elevation 31 of the frame 26 lies within the relevant boundary edges of the opening 24, the inside outer dimensions of the U-shaped elevation 31 corresponding exactly to the inside inner dimensions of the opening 24. In this way, at its inner edge the U-shaped elevation 31 serves to guide the chip card 20 which can be pushed via the ramp 32 towards the guide plate 33 and onto the contacting device 23 and the contact sprung ends 38 thereof. A corresponding end stop for the chip card 20 can be formed on the guide plate 33 or can be formed by one or more components on the circuit board 16. The distance of the contacting device 23 from the opening 24 or the rear boundary thereof in the insertion direction is however such that, as shown in Figure 2, in its inserted state the chip card 20 can be "gripped" at its surface, for example by frictional engagement with a finger-tip, and removed from the frame-like element 22 via the ramp 23.

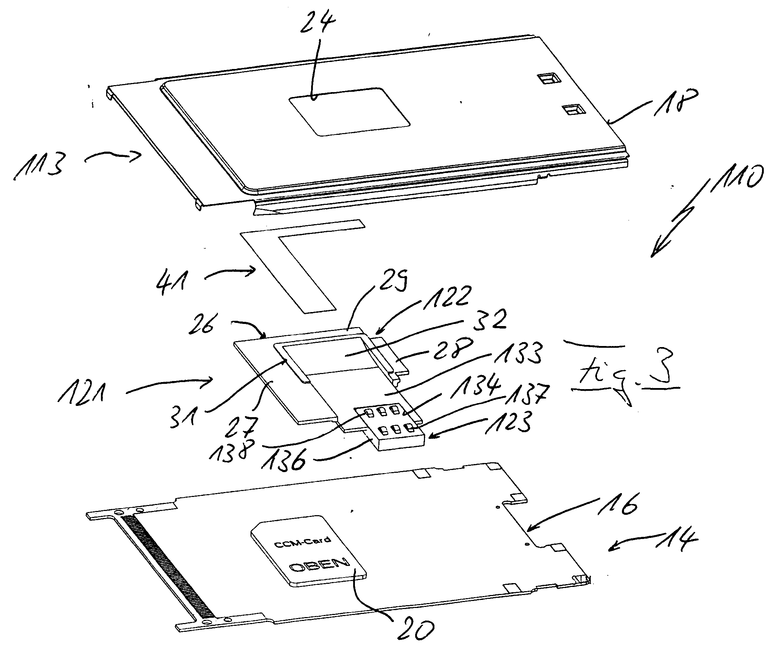

In the second exemplary embodiment illustrated in Figure 3, frame-like element 122 and contacting device 123 constitute two interconnected yet separate components. For this purpose, the guide plate 133 comprises a recess 134 which is open at its free end and into which the mounting plate 136 of the contacting device 123 is snugly held and secured. The permanent connection can take place by force-locking or shape-locking or adhesion. Otherwise the device 121 corresponds to the device 21 according to Figures 1 and 2 and is pre-mounted on the upper housing part 113 in the same manner.

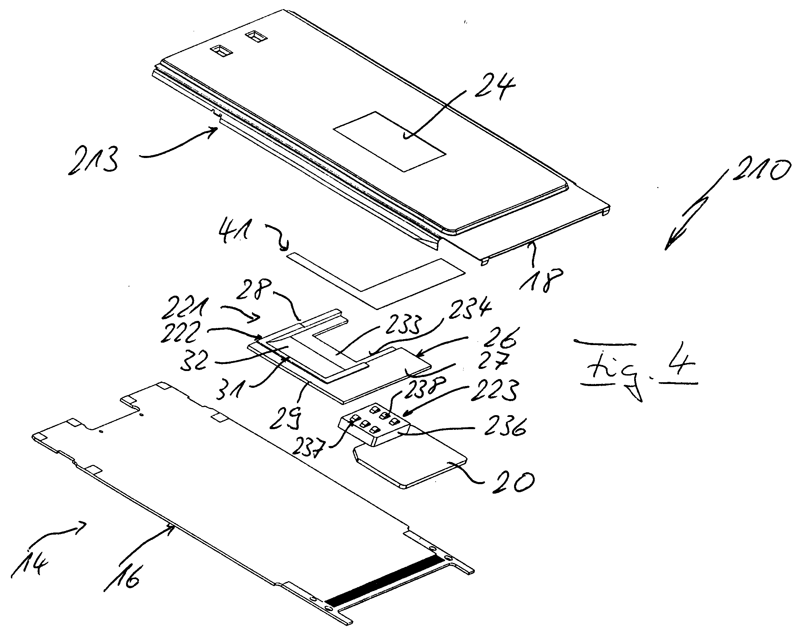

The plug-in card 210 shown in Figure 4 differs from the plug-in card 110 shown in Figure 3 inasmuch as the frame-like element 222 and the contacting device 323 of the device 221 are not only formed separately from one another but are also mounted on different parts of the plug-in card 210. Thus, as previously, the frame-like element 222 is secured on the upper housing part 213, for example by an adhesive connection, while the contacting device 223 is secured on the circuit board 16 however. For this purpose the downwardly projecting second contact ends (not shown here) are of pin-like formation so that they can be soldered in corresponding metallized bores of the circuit board 16 in a manner which has not been shown. Here the positioning of the contacting device 223 on the circuit board 16 is such that upon the assembly of the plug-in card 210, the mounting plate 236 of the contacting device 223 fits snugly into the recess 234 of the guide plate 233.

Although in the case of the illustrated plug-in card 10, 110, 210, which does not comprise a moveable cover of the opening 24 for the insertable or inserted chip card 20, the frame-like element 22, 122, 222 is attached to the underneath of the upper housing part 13, 113, 213, it will be obvious that the lower housing part (not shown here) can be used instead for this purpose.

In accordance with an exemplary embodiment which has not been illustrated, the frame-like element 22, 122, 222 is applied to the relevant housing part not from the underneath but from the upper side through the opening 24. For this purpose the frame-like element is provided with a U-shaped collar which projects beyond the relevant inside dimension of the opening 24 and which, surrounding the opening 24 for example in a U-formation, rests and is supported on the upper side of the relevant housing part. For this purpose it can be expedient to arrange the opening 24 in a depression which is formed in the relevant housing part and which accommodates the bearing collar.

The L-shaped adhesive strip 41 provided for the adhesive connection can be rendered conductive for shielding purposes in a manner not shown here.

## Claims

1. A plug-in card (10, 110, 210) for electronic devices of approximately oblong, flat formation with a housing comprising an upper and a lower, substantially half-shell-shaped housing part (13, 113, 213), a circuit board (16) accommodated in the housing, a contacting device (23, 123, 223) for a chip card (20) such as for example a SIM-, CCM-or the like card, and an accommodating means (21, 121, 221) for the chip card (20), characterised in that the chip card accommodating means (21, 121, 221) comprises a frame-like element (22, 122, 222) which is mounted on the laminar side of one of the housing parts (13, 113, 213) and is at least partially connected to an opening (24) in the laminar side of the relevant housing part (13, 113, 213) and in which the inserted chip card (20) can be accommodated, guided to the contacting device (23, 123, 223), and that the contacting device (23, 123, 223) is accommodated at one end of the frame-like element (22, 122, 222).

2. A plug-in card according to Claim 1, characterised in that the frame-like element (22, 122, 222) is secured on the underneath of the relevant housing part (13, 113, 213).

3. A plug-in card according to Claim 2, characterised in that the frame-like element (22, 122, 222) is adhesively attached to the underneath of the relevant housing part (13, 113, 213).

4. A plug-in card according to Claim 1, characterised in that the frame-like element is inserted in the opening (24) of the relevant housing part (13, 113, 213), resting on the upper side at its edge.

5. A plug-in card according to at least one of the preceding claims, characterised in that the frame-like element (22, 122, 222) comprises a feed ramp (32).

6. A plug-in card according to Claim 5, characterised in that the ramp (32) of the frame-like element (22, 122, 222) is extended by a strip-shaped or laminar guide element (33).

7. A plug-in card according to at least one of Claims 1 to 6, characterised in that the frame-like element (22, 122, 222) and a contact holder (36, 136, 236) of the contacting device (22, 122, 222) are of integral formation.

8. A plug-in card according to Claim 7, characterised in that the frame-like element (22, 122, 222) is injection-moulded around the contacts (37) of the contacting device (23, 123, 223).

9. A plug-in card according to at least one of Claims 1 to 6, characterised in that a contact holder (36, 136, 236) of the contacting device (23, 123, 223) is accommodated without play in a recess (34, 134, 234) of the frame-like element (22, 122, 222).

10. A plug-in card according to Claim 9, characterised in that the contacting device (22, 122, 222) is attached via its contacts (37) to the circuit board (16) by a soldering connection.

11. A plug-in card according to at least one of the preceding claims, characterised in that the contacting device (23, 123, 223) is arranged on the frame-like element (22, 122, 222) at a distance from the adjacent edge of the opening (24) in the relevant housing part (13, 113, 213) such as to permit the gripping of the surface of the inserted chip card (20) through the opening (24).
